# EUROPÄISCHE PATENTANMELDUNG

(11) **EP 4 354 435 A1**
(43) Veröffentlichungstag der Anmeldung: **17.04.2024**
(21) Anmeldenummer: 22200827.8
(22) Anmeldetag: 11.10.2022
(51) Int. Cl.: G11C 7/10, G06F 7/523, G06N 3/063

(54) **ANORDNUNG EINER ANALOGEN MULTIPLIKATIONSEINHEIT MIT BINÄREN MULTIPLIKANDEN**

(71) Anmelder: Semron GmbH, 01067 Dresden (DE)
(72) Erfinder: Demasius, Kai-Uwe, 01324 Dresden (DE); Pozhidaev, Vadim, 72764 Reutlingen (DE)
(74) Vertreter: Lippert Stachow Patentanwälte Rechtsanwälte Partnerschaft mbB

(57) **Zusammenfassung**

Der Erfindung, die eine Anordnung einer analogen Multiplikationseinheit mit binären Multiplikanden betrifft, die eine Matrix von Multiplikanden aufweist, wobei die Zeilen die Wortleitungen bilden und die Spalten die Bitleitungen und der Multiplikand eine Binärzahl ist, und die eine Treiberschaltung aufweist, welche eine Referenzspannung generierende Treiberschaltung enthält, liegt die Aufgabe zugrunde, einen Ansatz zu entwickeln, bei dem die Referenzspannung nicht mehr mit der Pulsweite des Eingabewertes geschalten wird und die Referenzspannung auf einer Gate-Kapazität weiter erhalten bleibt, die Anzahl der Eingangsleitungen reduziert, und eine kompakte Bauweise ermöglicht wird. Dies wird dadurch gelöst, dass die Eingangswerte an die Wortleitungen direkt angeschlossen werden und die Referenzspannung zur Generierung des Entladestroms durch die Speicherzelle selber gesteuert wird. Das heißt die Eingangswerte, kodiert mit der Pulsweite, werden nicht an einen eingangsseitigen Schalter verbunden und die Referenzspannung ist nicht durch den Eingangswert geschalten.

## Beschreibung

In den letzten Jahren, gab es ein zunehmendes Interesse analoge Vektor-Matrix-Multiplikationen durchzuführen mittels Speicherzellen, welche einen Multiplikanden darstellen. Die Speicherzellen sind hierbei in Matrixform angeordnet und stellen die Koeffizienten dar und die Eingangswerte werden an die horizontalen Leitungen angelegt, welche die Wortleitungen sind. Die Akkumulationsoperation erfolgt meist unter Ausnutzung des Kirchhoffschen Gesetzes, indem die Ausgangsströme der Speicherzellen sich aufsummieren.

Anwendungen solcher Anordnungen sind vor allem in der Berechnung von künstlichen neuronalen Netzen oder dem Lösen von Differentialgleichungen.

Eine Möglichkeit ist die Nutzung von nicht-volatilen Speichern, wie z.B. resistiven Speichern (e.g. Ielmini et al.: "In-memory computing with resistive switching devices". Nature Electronics, 2018). Diese Speicher haben den Vorteil, dass die multi-Bit Multiplikanden direkt analog in einer Speicherzelle gespeichert werden, gleichzeitig aber häufig eine nachteilige neue Prozessentwicklung bei der Herstellung erfordern und den Wert nicht präzise speichern können.

Demgegenüber steht die Nutzung von SRAM Speicherzellen, welche aus 6 Transistoren bestehen und eine präzise Speicherung von Multiplikanden ermöglicht. Hierbei wird die parasitäre Bitleitungskapazität mit einer Referenzspannung geladen und anschließend je nach Zustand der Summe der SRAM Zellen zu einem gewissen Teil entladen. Die Spannungsdifferenz zwischen positiver und negativer Bitleitung wird mit einem Analog-Digital-Wandler wieder in ein binäres Ergebnis konvertiert.

Eine SRAM Zelle kann jedoch nur einen binären Wert speichern. Um eine Multi-Bit Speicherung zu ermöglichen muss für jedes Bit eine SRAM Zelle vorgesehen werden. Die Akkumulation für jedes Bit kann separat erfolgen und für das Endergebnis ist eine anschließende digitale Skalierung mit Addition notwendig. Nachteil hierbei ist ein großer Schaltungstechnischer Aufwand um die Skalierung im digitalen durchzuführen.

Um eine analoge Akkumulation über mehrere SRAM Zellen zu erzielen, welche eine verschiedene Wertigkeit für jedes Bit besitzen, ist eine analoge Skalierung notwendig, welche in folgenden Konfigurationen möglich ist:
In US9697877 ist für jede SRAM Zelle eines Multiplikanden eine eigene Wortleitung vorgesehen, wobei der Eingangswert als Pulsweite moduliert ist und an die Wortleitung appliziert wird. In jeder Wortleitung wird eine Skalierung der Pulsweite so vorgenommen, dass jeweils die Wertigkeit des Bits repräsentiert wird. Nachteil hiervon ist, dass 6 Wortleitungen notwendig sind und die Zeitdauer der Pulsweite bei einer hohen Wertigkeit signifikant wird, wenn eine hohe Eingangspräzision gewährleistet werden soll.

In US10860682 ist für jede erhält jede SRAM Zelle eine andere Wertigkeit, indem die einzelnen Bitzellen in verschiedene Spalten angeordnet sind und die Ladungen der Bitleitungen nach der Akkumulationsoperation geteilt werden und dabei Nachbarkapazitäten ein Verhältnis von zwei haben. Das heißt die Wertigkeit wird an den Bitleitungen am Ende vorgenommen. Nachteil dieser Anordnung ist eine zeitliche Verzögerung, da eine weitere Operation nach der Akkumulation vorgenommen werden muss und die eine weitere Beschaltung an der unteren Bitleitung notwendig ist. Unter eine ähnliche Kategorie fällt auch US20220012016.

In US11263522 werden die SRAM Zellen mit unterschiedlich dimensionierten Kapazitäten verbunden, um die Wertigkeit der Bits zu erreichen. Nachteil dieser Anordnung ist der erhöhte Platzbedarf zur Realisierung der zusätzlichen Kapazitäten und ein erhöhter Energieverbrauch, da eine größere Kapazität geladen werden muss.

In WO2020112485A1 besitzt jede Speicherzelle eine SRAM Zelle und ein Transistorpaar in Reihe, wobei ein Transistorpaar von dem Ausgang der SRAM Zelle kontrolliert wird und an dem anderen Transistor eine Referenzspannung appliziert wird, welche über einen eingangsseitigen Schalter kontrolliert wird. Der eingangsseitige Schalter wird durch die Pulsweite des Eingangswertes kontrolliert. Die Referenzspannung generiert in der Speicherzelle einen Endladestrom für die Bitleitungskapazität und der Entladestrom ist proportional zur Wertigkeit des gespeicherten Bits der Speicherzelle. Die Referenzspannung wird von einer Treiberschaltung mit Stromspiegeln generiert. Problem dieser Anordnung ist, dass der eingangsseitige Schalter das Gate von dem einen Transistor des Transistorpaares offenlässt, sodass die Referenzspannung selbst beim Ende des Eingangspulses auf dem Gate erhalten bleibt und der Stromfluss für längere Zeit weiterfließt, anstatt unterbrochen zu werden. Weiterhin sind wieder 6 Eingangsleitungen notwendig und eine externe Treiberschaltung notwendig.

Da die Anmeldung WO2020112485A1 diesem Patent am nächsten kommt, wird diese als Stand der Technik berücksichtigt.

Aufgabe der Erfindung ist es, einen Ansatz zu entwickeln, der die Nachteile des Standes der Technik beseitigt, das heißt, dass die Referenzspannung nicht mehr mit der Pulsweite des Eingabewertes geschalten wird und die Referenzspannung auf einer Gate-Kapazität weiter erhalten bleibt, die Anzahl der Eingangsleitungen reduziert, und eine kompakte Bauweise ermöglicht wird.

Erfindungsgemäß wird diese Aufgabe dadurch gelöst, dass die Eingangswerte an die Wortleitungen direkt angeschlossen werden und die Referenzspannung zur Generierung des Entladestroms durch die Speicherzelle selber gesteuert wird. Das heißt die Eingangswerte, kodiert mit der Pulsweite, werden nicht an einen eingangsseitigen Schalter verbunden und die Referenzspannung ist nicht durch den Eingangswert geschalten.

In einer weiteren günstigen Ausführungsform, repräsentiert die Referenzspannungshöhe die Wertigkeit des Bits in dem Multiplikanden. Hierdurch wird sichergestellt, dass in jeder Speicherzelle ein Entladestrom generiert wird, welcher exakt proportional zur Wertigkeit des Bits ist.

In einer weiteren günstigen Ausführungsform, ist die Speicherzelle eine SRAM Zelle ist, dessen Versorgungsspannung so ausgebildet ist, dass diese identisch mit der Höhe der Referenzspannung ist. Hierdurch ist die Ausgangsspannung der SRAM Zelle entweder Null oder identisch mit der Referenzspannung. Diese Ausgangsspannung kontrolliert letztlich den Entladestrom, je nachdem ob eine Null oder eine Eins in der Zelle gespeichert wurde.

In einer vierten Ausführungsform, enthält die Speicherzelle eine Kaskode, wobei der Gateanschluss des Transistors in Gateschaltung mit dem Eingangssignal über die Wortleitung verbunden ist und der Gateanschluss des Transistors in Sourceschaltung mit dem Ausgang der Speicherzelle verbunden ist.

Der Vorteil einer Kaskode ist, dass der Ausgangswiderstand sehr groß ist, was günstig für Stromquellen und Stromspiegel ist. Die Gateschaltung wird hierbei von dem Eingangssignal kontrolliert. Wenn dieses Null ist wird der Entladestrom unterbrochen, ansonsten wird die Gateschaltung mit einer konstanten Spannung beaufschlagt und der Entladestrom weitergeleitet. Die Sourceschaltung ist mit dem Ausgang der Speicherzelle verbunden und dieser ist entweder Null Volt oder die entsprechende Referenzspannung. Im Falle von Null Volt wird kein Entladestrom erzeugt, im anderen Fall ein Entladestrom, welcher die Wertigkeit des Bits widerspiegelt. Weitere günstige Ausführungsformen sind in folgenden Zeichnungen erklärt:
Fig. 1: Eine SRAM Zelle mit einer Kaskodenbeschaltung für die Entladestrom Generierung, wobei auch der invertierte Ausgang der Zelle genutzt wird.
Fig. 2: Eine SRAM Zelle mit einer Kaskodenbeschaltung für die Entladestrom Generierung, wobei nur ein Ausgang genutzt wird.

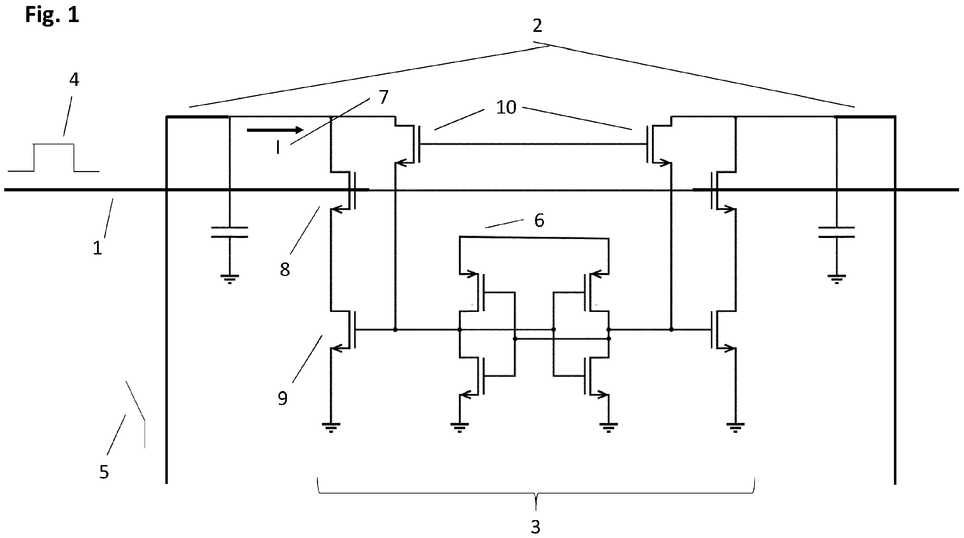

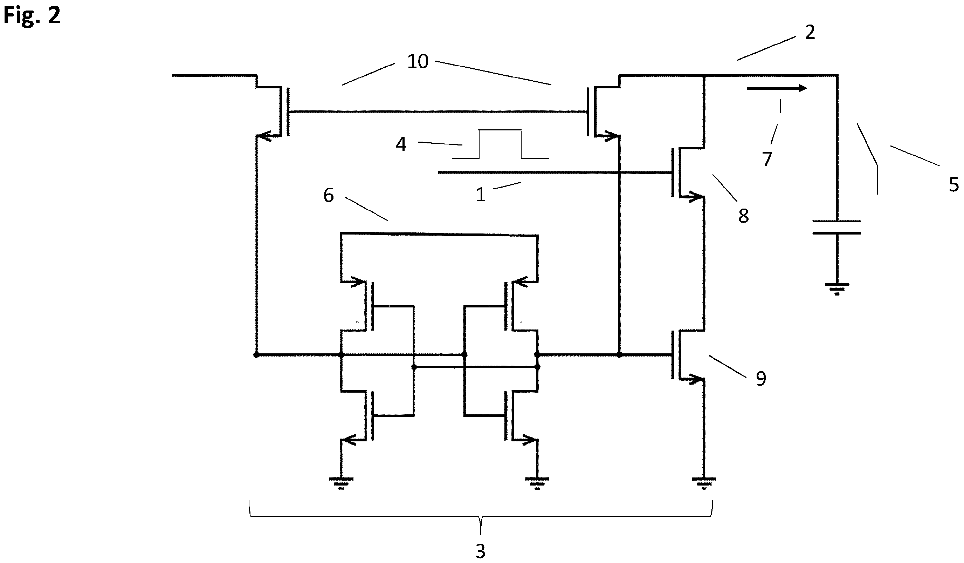

Wie aus Fig. 1 ersichtlich ist, wird eine Standard-SRAM-Zelle mit zwei kreuzgekoppelten Invertern genutzt. Ebenso sind zwei Auswahltransistoren (10) zum Schreiben vorhanden. Zusammengenommen ergibt sich eine 6T SRAM Zelle. Weiterhin ist jeder Ausgang der SRAM Zelle mit jeweils einer Kaskode verbunden. Der Gateanschluss der Gateschaltung (8) wird mit dem Eingangssignal (4) (PWM Puls) verbunden und steuert den Entladestromfluss (7). Der Gateanschluss der Sourceschaltung (9) wird mit dem Ausgang der SRAM Zelle verbunden. Der Entladestrom entlädt und verändert die Spannung der parasitären Kapazität der Bitleitung (2), welche das Ausgangssignal (5) und das Resultat der Multiplikation repräsentiert. Das Eingangssignal (4) wird an die Wortleitung (1) angeschlossen. Die Ausgangsspannung der SRAM Zelle ist durch Speicherzustand der Zelle und der Versorgungsspannung bestimmt. Die Versorgungsspannung ist identisch zur Referenzspannung (6). Wenn eine Null gespeichert ist, ist ein Ausgang Null Volt und der andere identisch zu Referenzspannung (6). Die Referenzspannung (6) determiniert letztlich den Entladestrom (7) und wird so gewählt, dass die Wertigkeit des Bits widergespiegelt wird. Das Ausführungsbeispiel aus Fig. 2 ist ähnlich zu dem aus Fig. 1, bis auf, dass nur ein Ausgang der SRAM Zelle genutzt wird. Nur an dem rechten Ausgang ist eine Kaskode angeschlossen, was eine Reduktion der Anzahl an Transistoren ermöglicht.

### Bezugszeichenliste

- 1: Wortleitung
- 2: Bitleitung
- 3: Speicherzelle
- 4: Eingangssignal
- 5: Ausgangssignal
- 6: Referenzspannung
- 7: Entladestrom
- 8: Gateschaltung der Kaskode
- 9: Sourceschaltung der Kaskode
- 10: Auswahltransistor

## Patentansprüche

1. Anordnung einer analogen Multiplikationseinheit mit binären Multiplikanden mit einer Matrix von Multiplikanden, wobei die Zeilen die Wortleitungen (1) bilden und die Spalten die Bitleitungen (2), und der Multiplikand eine Binärzahl ist, wobei jedes Bit der Binärzahl in einer eigenen Speicherzelle (3) gespeichert ist, und jede Speicherzelle so ausgebildet ist, dass diese einen Eingangswert (4) erhält, welcher den Multiplikator repräsentiert und der Wert als Pulsweite moduliert ist, und die Speicherzelle (3) so ausgebildet ist, dass diese deren Ausgabe (5) ausgibt, welche ein Produkt der Multiplikation repräsentiert und die eine Treiberschaltung enthält, welche einen Referenzspannung (6) generierende Treiberschaltung enthält, welche einen Entladestrom (7) generierend, welcher der proportional zur Signifikanz des Bits ist, ausgebildet ist, **dadurch gekennzeichnet, dass** die Eingangswerte (4) an die Wortleitungen (1) direkt angeschlossen werden und die Referenzspannung (6) zur Generierung des Entladestroms (7) durch die Speicherzelle (3) selber gesteuert steuerbar ist.

2. Anordnung nach Anspruch 1, dadurch
ge kenn z e ichnet, dass die Referenzspannungshöhe die Wertigkeit des Bits in dem Multiplikanden repräsentiert.

3. Anordnung nach Anspruch 1 oder 2, dadurch gekenn z e ichnet, dass die Speicherzelle als eine SRAM Zelle ausgebildet ist, deren Versorgungsspannung identisch mit der Höhe der Referenzspannung (6) ist.

4. Anordnung nach Anspruch 1 oder 2 oder 3, dadurch gekenn z e ichnet, dass die Speicherzelle eine Kaskode enthält, wobei der Gateanschluss des Transistors in Gateschaltung (8) mit dem Eingangssignal über die Wortleitung verbunden ist und der Gateanschluss des Transistors in Sourceschaltung (9) mit dem Ausgang der Speicherzelle verbunden ist.
